# EUROPEAN PATENT APPLICATION

(11) **EP 3 442 040 A1**
(43) Date of publication of application: **13.02.2019**
(21) Application number: 17774860.5
(22) Date of filing: 27.03.2017
(51) Int. Cl.: H01L 41/087, G01L 1/16, H01L 41/09, H01L 41/113, H01L 41/193, H01L 41/45

(54) **PIEZOELECTRIC WIRE AND PRODUCTION METHOD FOR SAME, AND PIEZOELECTRIC DEVICE PROVIDED WITH PIEZOELECTRIC WIRE**

(30) Priority: 31.03.2016 JP 2016070220
(71) Applicant: Toho Kasei Co., Ltd., Yamatokoriyama-shi, Nara 639-1031 (JP); Daikin Industries, Ltd., Osaka-shi, Osaka 530-8323 (JP)
(72) Inventor: OGASAHARA, Ken, Nara 639-1031, (JP); SHIMIZU, Satoshi, Nara 639-1031, (JP); KAWATO, Susumu, Nara 639-1031, (JP); KANEMURA, Takashi, Osaka 566-8585, (JP); KODANI Tetsuhiro, Osaka 566-8585, (JP)
(74) Representative: Diehl & Partner GbR
(86) International application number: PCT/JP2017/012240
(87) International publication number: WO 2017/170323

(57) **Abstract**

A piezoelectric wire of the present invention includes a conductive wire 11 and a polymer piezoelectric layer 12 that coats the conductive wire 11. The polymer piezoelectric layer 12 contains a β-phase polyvinylidene fluoride-based copolymer, and the conductive wire 11 has a wire diameter of 1.0 mm or less. The β-phase polyvinylidene fluoride-based copolymer is preferably at least one selected from a vinylidene fluoride-trifluoroethylene copolymer and a vinylidene fluoride-tetrafluoroethylene copolymer.

## Description

### Technical Field

The present invention relates to an ultrafine piezoelectric wire and a production method of the piezoelectric wire, and a piezoelectric device including the piezoelectric wire.

### Background Art

Piezoelectric elements are elements utilizing piezoelectric materials, which are substances converting an electrical energy into a mechanical energy or a mechanical energy into an electrical energy. The piezoelectric elements are used for various actuators by utilizing the inverse piezoelectric effect of converting an electrical energy into a mechanical energy, and for various sensors and vibration-type power generation elements by utilizing the positive piezoelectric effect of converting a mechanical energy into an electrical energy.

Along with downsizing of devices utilizing piezoelectric elements, cable-like piezoelectric elements with a high degree of freedom in installation to devices have drawn attention recently. For example, Patent Document 1 proposes a cable-like piezoelectric sensor comprising an internal conductor, a flexible insulator, an outer conductor including a piezoelectric layer and a metal layer, and a flexible sheath. A polymer piezoelectric material such as polyvinylidene fluoride is used for the piezoelectric layer.

### Prior Art Documents

### Patent Documents

Patent Document 1: JP 2005-351664 A
Patent Document 2: JP 2005-200623 A

### Disclosure of Invention

### Problem to be Solved by the Invention

However, polyvinylidene fluoride, which is described to be usable as a piezoelectric material in Patent Document 1, requires complex after-treatment such as drawing to exhibit a strong dielectric property. In the case of using polyvinylidene fluoride by coating on a fine metal wire or the like, it is difficult to perform after-treatment such as drawing after the coating. There is also a method in which polyvinylidene fluoride is formed into a film and then drawn, and the drawn film is attached to a metal wire to cover the metal wire. However, this method is difficult to implement when the metal wire is thin.

The present invention has been achieved to solve the above problem, and its object is to provide an ultrafine piezoelectric wire that is coated with a polymer piezoelectric material that exhibits a strong dielectric property without requiring after-treatment such as drawing.

### Means for Solving Problem

A piezoelectric wire of the present invention is a piezoelectric wire including a conductive wire and a polymer piezoelectric layer that coats the conductive wire. The polymer piezoelectric layer contains a β-phase polyvinylidene fluoride-based copolymer, and the conductive wire has a wire diameter of 1.0 mm or less.

A piezoelectric device of the present invention includes the piezoelectric wire of the present invention.

A first production method of the piezoelectric wire of the present invention includes: a resin solution preparation step of preparing a resin solution by dissolving a β-phase polyvinylidene fluoride-based copolymer in a solvent; an application step of applying the resin solution to a conductive wire; a piezoelectric layer formation step of forming a polymer piezoelectric layer on a surface of the conductive wire by heating the conductive wire to which the resin solution has been applied; and a polarization step of polarizing the polymer piezoelectric layer without drawing of the polymer piezoelectric layer.

A second production method of the piezoelectric wire of the present invention includes: a resin melting step of melting a β-phase polyvinylidene fluoride-based copolymer by heating to prepare a molten resin; an extrusion coating step of coating a conductive wire with the molten resin to form a polymer piezoelectric layer on a surface of the conductive wire; and a polarization step of polarizing the polymer piezoelectric layer without drawing of the polymer piezoelectric layer.

### Effect of the Invention

The present invention provides an ultrafine, high-sensitive piezoelectric wire coated with a polymer piezoelectric material that exhibits a strong dielectric property without requiring after-treatment such as drawing.

### Brief Description of Drawings

[FIG. 1] FIG. 1 is an enlarged front view illustrating an exemplary piezoelectric wire of the present invention.
[FIG. 2] FIG. 2 is a perspective view of the piezoelectric wire illustrated in FIG. 1.
[FIG. 3] FIG. 3 is an enlarged front view illustrating another exemplary piezoelectric wire of the present invention.
[FIG. 4] FIG. 4 is a perspective view of the piezoelectric wire illustrated in FIG. 3.
[FIG. 5] FIG. 5 is an enlarged front view illustrating another exemplary piezoelectric wire of the present invention.
[FIG. 6] FIG. 6 is a perspective view of the piezoelectric wire illustrated in FIG. 5.
[FIG. 7] FIG. 7 is a schematic diagram illustrating a state of measuring an inverse piezoelectric effect of the piezoelectric wire of the present invention.
[FIG. 8] FIG. 8 is a schematic diagram illustrating a state of measuring a positive piezoelectric effect of the piezoelectric wire of the present invention.
[FIG. 9] FIG. 9 is a graph illustrating a relationship between a wire diameter and a displacement amplitude p-p of wires of Examples 1 to 4.
[FIG. 10] FIG. 10 is a graph illustrating a relationship between a wire diameter and an output voltage per unit thickness of a resin layer of the wires of Examples 1 to 4.

### Description of the Invention

### (Piezoelectric Wire of the Present Invention)

First, a piezoelectric wire of the present invention will be described. The piezoelectric wire of the present invention includes a conductive wire and a polymer piezoelectric layer that coats the conductive wire. The polymer piezoelectric layer contains a β-phase polyvinylidene fluoride-based copolymer, and the conductive wire has a wire diameter (diameter) of 1.0 mm or less.

Since a β-phase polyvinylidene fluoride-based copolymer is used as a piezoelectric material in the piezoelectric wire of the present invention, the piezoelectric wire can exhibit a strong dielectric property without requiring after-treatment such as drawing. Because of this, even when the wire diameter of the conductive wire is 1.0 mm or less, polarization becomes possible and a polymer piezoelectric layer can be formed merely by coating the surface of the conductive wire with the β-phase polyvinylidene fluoride-based copolymer. Thus, a piezoelectric wire with a high degree of freedom in installation to a device can be produced.

Moreover, in the piezoelectric wire of the present invention, since the wire diameter of the conductive wire is set to 1.0 mm or less, the piezoelectric wire is flexible and has high sensitivity to exhibit an inverse piezoelectric effect and a positive piezoelectric effect. In other words, the piezoelectric wire of the present invention as a flexible piezoelectric element can reliably convert even a small electrical energy into a mechanical energy and convert even a small mechanical energy into an electrical energy.

The β-phase polyvinylidene fluoride-based copolymer is preferably at least one selected from a vinylidene fluoride-trifluoroethylene copolymer and a vinylidene fluoride-tetrafluoroethylene copolymer because these copolymers have a strong dielectric property and high heat resistance. Here, the "strong dielectric property" is a property of maintaining polarization even when there is no external electric field. The "heat resistance" is a property of maintaining polarization even when the temperature is at 85°C.

The "vinylidene fluoride-trifluoroethylene copolymer" contains 50 mol% or more (preferably 60 mol% or more) of a repeating unit derived from vinylidene fluoride. A mole ratio of (a repeating unit derived from trifluoroethylene) / (the repeating unit derived from vinylidene fluoride) in the "vinylidene fluoride-trifluoroethylene copolymer" is preferably within a range of 5/95 to 36/64, more preferably within a range of 15/85 to 25/75, and further preferably within a range of 18/82 to 22/78.

The "vinylidene fluoride-tetrafluoroethylene copolymer" contains 50 mol% or more (preferably 60 mol% or more) of a repeating unit derived from vinylidene fluoride. A mole ratio of (a repeating unit derived from tetrafluoroethylene) / (the repeating unit derived from vinylidene fluoride) in the "vinylidene fluoride-tetrafluoroethylene copolymer" is preferably within a range of 5/95 to 36/64, more preferably within a range of 15/85 to 25/75, and further preferably within a range of 18/82 to 22/78.

The molecular weight of the β-phase polyvinylidene fluoride-based copolymer is not particularly limited, and for example, polymers having a number average molecular weight of 10,000 to 1,000,000 may be used.

The polymer piezoelectric layer may contain an additive in addition to the β-phase polyvinylidene fluoride-based copolymer. Examples of the additive include piezoelectric ceramic such as lead titanate sintered powder, lead zirconate titanate sintered powder, non-lead piezoelectric ceramic sintered powder (e.g., sodium niobate), and aluminum nitride.

The thickness of the polymer piezoelectric layer is not particularly limited, but it is generally set to 2 µm or more and 200 µm or less because the flexibility and sensitivity of the piezoelectric wire tend to deteriorate when the polymer piezoelectric layer is too thick.

Although the conductive wire is set to have a wire diameter of 1.0 mm or less, it is preferably ultrafine with a wire diameter of 0.5 mm or less. By doing so, it is possible to obtain a piezoelectric wire having more flexibility and higher sensitivity to exhibit an inverse piezoelectric effect and a positive piezoelectric effect. The lower limit of the wire diameter of the conductive wire is not particularly limited as long as the conductive wire is produceable. For example, the wire diameter is set to 0.008 mm or more for smoother handling and production of the wire.

The type of the conductive wire is not particularly limited as long as the wire has conductivity, and examples thereof include a metal wire, a conductive-coated wire in which a surface of a resin wire is coated with a conductive layer, and a conductive polymer wire. Among these, a metal wire having a high tensile strength is preferred. When the conductive wire is a metal wire, the type of the metal to be used is not particularly limited, and examples thereof include copper, nickel, aluminum, and stainless steel.

The form of the conductive wire is not particularly limited, and examples thereof include a single wire and a strand.

The piezoelectric wire of the present invention may further include a conductive layer on an outer surface of the polymer piezoelectric layer. The material for forming the conductive layer is not particularly limited, and examples thereof include a metal and a conductive polymer.

The piezoelectric wire of the present invention may further include an insulating layer on an outer surface of the conductive layer. This improves a degree of freedom in an arrangement for installation of the piezoelectric wire of the present invention to a device or the like. The material for forming the insulating layer is not particularly limited, and examples thereof include an organic material and an inorganic material. A resin material with flexibility is preferred.

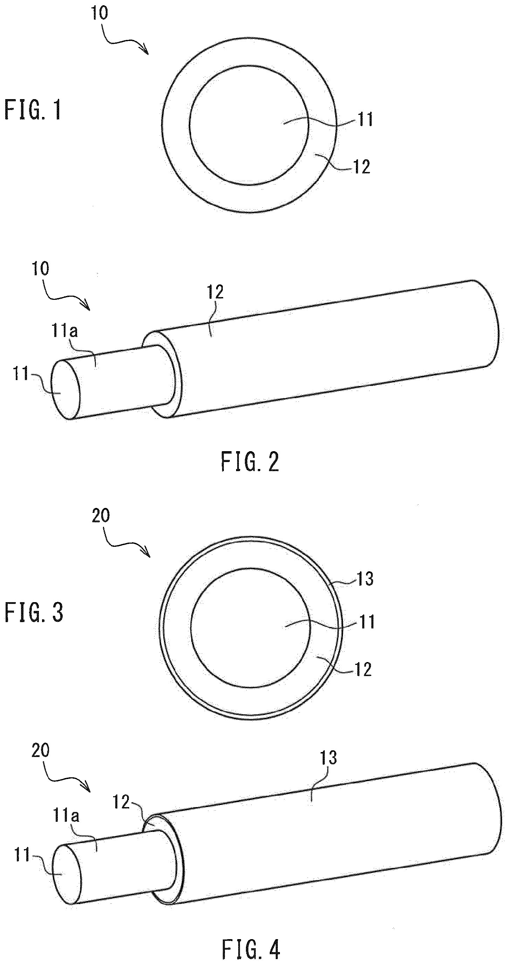

Hereinafter, the piezoelectric wire of the present invention will be described with reference to the drawings. FIG. 1 is an enlarged front view illustrating an exemplary piezoelectric wire of the present invention, and FIG. 2 is a perspective view of the piezoelectric wire illustrated in FIG. 1. In FIGS. 1 and 2, a piezoelectric wire 10 of the present invention includes a conductive wire 11 and a polymer piezoelectric layer 12 that coats the conductive wire 11. The polymer piezoelectric layer is not formed at an end 11a of the conductive wire 11. The polymer piezoelectric layer 12 contains a β-phase polyvinylidene fluoride-based copolymer, and the conductive wire 11 has a wire diameter of 1.0 mm or less.

The piezoelectric wire is polarized without after-treatment such as drawing, has a piezoelectric property, and exhibits an inverse piezoelectric effect and a positive piezoelectric effect. Moreover, since the wire diameter of the metal wire is set to 1.0 mm or less, the piezoelectric wire is flexible and has high sensitivity.

FIG. 3 is an enlarged front view illustrating another exemplary piezoelectric wire of the present invention, and FIG. 4 is a perspective view of the piezoelectric wire illustrated in FIG. 3. A piezoelectric wire 20 illustrated in FIGS. 3 and 4 is a wire obtained by further forming a conductive layer 13 on an outer surface of the polymer piezoelectric layer 12 of the piezoelectric wire 10 illustrated in FIGS. 1 and 2. The formation of the conductive layer 13 facilitates polarization.

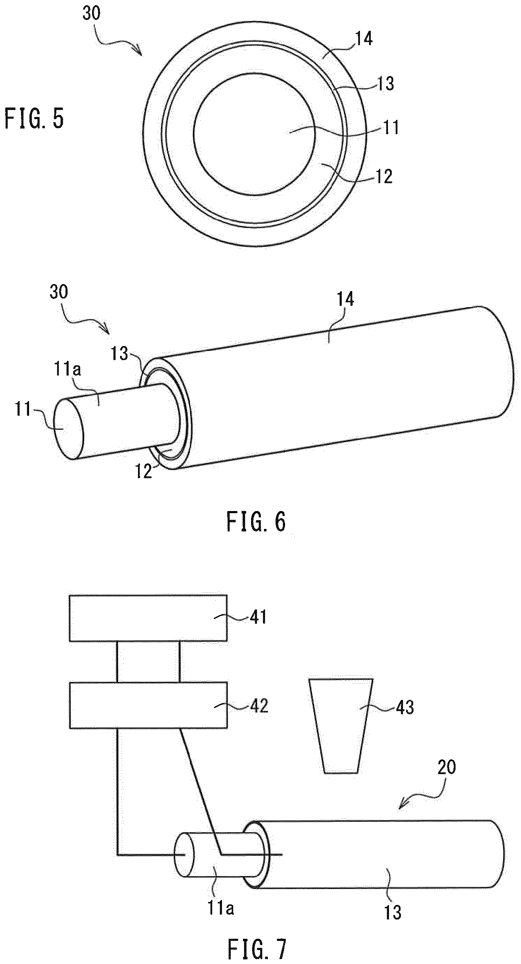

FIG. 5 is an enlarged front view illustrating still another exemplary piezoelectric wire of the present invention, and FIG. 6 is a perspective view of the piezoelectric wire illustrated in FIG. 5. A piezoelectric wire 30 illustrated in FIGS. 5 and 6 is a wire obtained by further forming an insulating layer 14 on an outer surface of the conductive layer 13 of the piezoelectric wire 20 illustrated in FIGS. 3 and 4. The formation of the insulating layer 14 improves a degree of freedom in an arrangement for installation of the piezoelectric wire 30 to a device or the like.

### (Production Method of Piezoelectric Wire of the Present Invention)

Next, first and second production methods of the piezoelectric wire of the present invention will be described.

The first production method of the piezoelectric wire of the present invention includes: a resin solution preparation step of preparing a resin solution by dissolving a β-phase polyvinylidene fluoride-based copolymer in a solvent; an application step of applying the resin solution to a conductive wire; a piezoelectric layer formation step of forming a polymer piezoelectric layer on a surface of the conductive wire by heating the conductive wire to which the resin solution has been applied; and a polarization step of polarizing the polymer piezoelectric layer without drawing of the polymer piezoelectric layer.

The second production method of the piezoelectric wire of the present invention includes: a resin melting step of melting a β-phase polyvinylidene fluoride-based copolymer by heating to prepare a molten resin; an extrusion coating step of coating a conductive wire with the molten resin to form a polymer piezoelectric layer on a surface of the conductive wire; and a polarization step of polarizing the polymer piezoelectric layer without drawing of the polymer piezoelectric layer.

Since the β-phase polyvinylidene fluoride-based copolymer is used as a piezoelectric material in the first and second production methods of the piezoelectric wire of the present invention, the piezoelectric wire obtained thereby can exhibit a strong dielectric property without requiring after-treatment such as drawing. Thus, even when the wire diameter of the conductive wire is as thin as 1.0 mm or less, a polymer piezoelectric layer having a strong dielectric property can be formed on the conductive wire only by coating the surface with the β-phase polyvinylidene fluoride-based copolymer. Thus, an ultrafine piezoelectric wire with a high degree of freedom in installation to a device can be produced.

Here, the "without drawing of the polymer piezoelectric layer" means that the polymer piezoelectric layer is not drawn before and after polarization.

The solvent to be used in the first production method is not particularly limited as long as it can dissolve the β-phase polyvinylidene fluoride-based copolymer and can be removed by heating after application of the resin solution. Examples of the solvent includes: ketone-based solvents such as methyl ethyl ketone (MEK), methyl isobutyl ketone (MIBK), acetone, diethyl ketone, and dipropyl ketone; ester-based solvents such as ethyl acetate, methyl acetate, propyl acetate, butyl acetate, and ethyl lactate; ether-based solvents such as tetrahydrofuran, methyltetrahydrofuran, and dioxane; and amide-based solvents such as dimethylformamide (DMF) and dimethylacetamide.

The molten resin in the second production method can be prepared, for example, by heating a pelletized β-phase polyvinylidene fluoride-based copolymer.

The first and second production methods can further include a step of forming a conductive layer on a surface of the polymer piezoelectric layer. The formation method of the conductive layer is not particularly limited, and may be, e.g., an evaporation method, a sputtering method, or a coating method.

Moreover, the first and second production methods can further include a step of forming an insulating layer on a surface of the conductive layer. The formation method of the insulating layer is not particularly limited, and the layer may be formed similarly to the formation of the polymer piezoelectric layer through the application step or the extrusion coating step.

As to the polarization in the first and second production methods, for example, known corona discharge may be adopted for a piezoelectric wire not having a conductive layer in the form of FIGS. 1 and 2 described above. For a piezoelectric wire having a conductive layer in the form of FIGS. 3 and 4, polarization can be performed by applying a direct voltage or an alternating voltage between the conductive wire 11 and the conductive layer 13. It is preferable to form the conductive layer 13 to polarize the polymer piezoelectric layer 12 uniformly.

### (Piezoelectric Device of the Present Invention)

A piezoelectric device of the present invention is provided with the piezoelectric wire of the present invention. Since the piezoelectric device of the present invention includes the ultrafine piezoelectric wire functioning as a piezoelectric element, the device has high sensitivity. Since the piezoelectric device of the present invention includes the ultrafine piezoelectric wire with a high degree of freedom in installation inside a device, the device can be downsized.

Examples of the piezoelectric device for use as a sensor include an impact sensor, a pressure sensing sensor, a pyroelectric sensor, an ultrasonic sensor, a biosignal detecting sensor, a distortion detecting sensor, a microphone, a pickup sensor, an acceleration sensor, a curvature sensor, a keyboard switch, a security sensor, and a vibration power generator. Examples of the piezoelectric device for use as an actuator include a speaker, a headphone, a hearing aid, a diaphragm, a compact pump, a shutter, and an artificial muscle.

### Examples

Hereinafter, the present invention will be described in more detail based on examples. However, the present invention is not limited to the following examples.

### (Example 1)

First, 30g of a vinylidene fluoride-trifluoroethylene copolymer (the mole ratio of vinylidene fluoride : trifluoroethylene = 75 : 25) was dissolved in 70 g of methyl ethyl ketone while heating to 70°C, and the mixture was stirred for 30 minutes by an ultrasonic homogenizer "BRANSON Digital Sonifire" (manufactured by Emerson Japan, Ltd.) to prepare a resin solution.

Next, the resin solution was applied to a stainless steel single wire 0.02 mm in diameter and 50 mm in length (manufactured by The Nilaco Corporation), by dip coating. The single wire to which the resin solution was applied was heated at 150°C for two minutes to vaporize and remove the methyl ethyl ketone, so that a resin layer having a thickness of 20 µm was formed on the surface of the wire. Thus, a coated wire was produced. An uncoated wire end part was left on one end of the coated wire.

Then, aluminum was evaporated on the entire surface of the resin layer of the coated wire to form an aluminum conductive layer. Next, using the aluminum conductive layer as a ground electrode and the uncoated wire end part as a counter electrode, the resin layer was polarized by applying a direct voltage of 6 kV from the counter electrode to the ground electrode for one minute by a high-voltage supply "610D" (manufactured by TREK, INC.). Thus, a piezoelectric wire of Example 1 was produced.

### (Example 2)

A piezoelectric wire of Example 2 was produced in the same manner as in Example 1 except that the wire diameter of the stainless steel single wire was 0.10 mm, and the thickness of the resin layer was 15 µm.

### (Example 3)

A piezoelectric wire of Example 3 was produced in the same manner as in Example 1 except that the wire diameter of the stainless steel single wire was 0.50 mm, and the thickness of the resin layer was 80 µm.

### (Example 4)

A piezoelectric wire of Example 4 was produced in the same manner as in Example 1 except that the wire diameter of the stainless steel single wire was 1.0 mm, and the thickness of the resin layer was 80 µm.

### (Example 5)

A piezoelectric wire of Example 5 was produced in the same manner as in Example 1 except that a vinylidene fluoride-tetrafluoroethylene copolymer (the mole ratio of vinylidene fluoride : tetrafluoroethylene = 80 : 20) was used as a piezoelectric resin, a copper strand (wire diameter: 0.52 mm) 50 mm in length in which 20 copper single wires (wire diameter: 0.08 mm) were twisted together was used as a wire, and the thickness of the resin layer was 18 µm.

The inverse piezoelectric effect and the positive piezoelectric effect of the piezoelectric wires of Examples 1 to 5 were evaluated as below.

### <Inverse Piezoelectric Effect>

As illustrated in FIG. 7, a function generator "WF 1973" (41) (manufactured by NF Corporation) and an amplifier "Model 610D" (42) (manufactured by TREK, INC.) were connected, and the amplifier (42) was electrically connected with the end 11a of the piezoelectric wire 20 and the conductive layer 13. Next, an alternating voltage of 10 Vp-p at a frequency of 5 Hz output from the function generator 41 was amplified to 1000 Vp-p by the amplifier 42 and applied to the piezoelectric wire 20. A displacement amplitude p-p (double displacement amplitude) of the piezoelectric wire at this time was measured by a laser microscope "VK-X150" (43) (manufactured by

### KEYENCE CORPORATION).

### <Positive Piezoelectric Effect>

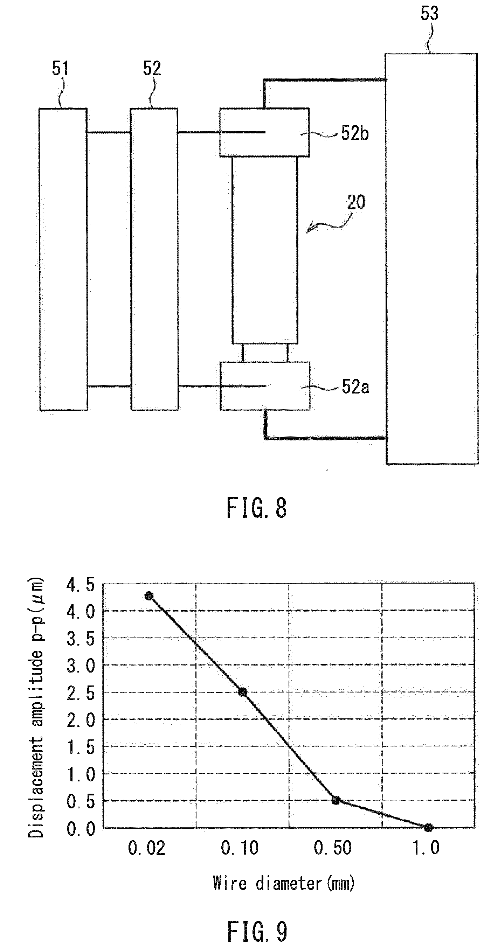

As illustrated in FIG. 8, both ends of the piezoelectric wire 20 were set in a tensile tester "AGS-500X" (53) (manufactured by Shimadzu Corporation). An oscilloscope 51 and a charge amplifier 52 (manufactured by Turtle Industry Co., Ltd.) were connected, and the charge amplifier 52 was electrically connected with the both ends of the piezoelectric wire 20 via electrodes 52a and 52b. Next, the both ends of the piezoelectric wire 20 were extended until the tension became 0.5 N, and then the tension was released to 0 at high speed. A piezoelectric output at this time was measured to calculate an output voltage per unit thickness of the polymer piezoelectric layer of the piezoelectric wire 20.

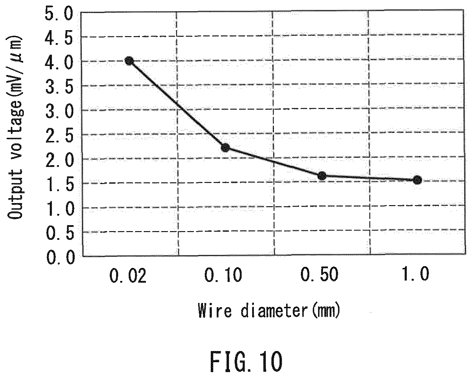

The results are shown in Table 1, FIGS. 9 and 10. Table 1 indicates the wire diameter and the thickness of the resin layer of each piezoelectric wire, together with the inverse piezoelectric effect and the positive piezoelectric effect. FIG. 9 is a graph illustrating a relationship between the wire diameter and the displacement amplitude p-p of the wires of Examples 1 to 4, and FIG. 10 is a graph illustrating a relationship between the wire diameter and the output voltage per unit thickness of the resin layer of the wires of Examples 1 to 4.

**[Table 1]**

| | Wire diameter (mm) | Thickness of resin layer (µm) | Displacement amplitude p-p (µm) | Output voltage (mV/µm) |
|---|---|---|---|---|
| Example 1 | 0.02 | 20 | 4.26 | 3.9 |
| Example 2 | 0.10 | 15 | 2.44 | 2.2 |
| Example 3 | 0.50 | 80 | 0.50 | 1.6 |
| Example 4 | 1.0 | 80 | 0 | 1.5 |
| Example 5 | 0.52 | 18 | 0.41 | 5.6 |

It was confirmed from Table 1 and FIG. 9 that, since the displacement amplitude p-p was observed in Examples 1 to 3 and 5, the piezoelectric wires of Examples 1 to 3 and 5 can exhibit the inverse piezoelectric effect. It was also confirmed from Table 1 and FIG. 10 that the piezoelectric wires of Examples 1 to 5 can exhibit the positive piezoelectric effect.

Moreover, the above results indicate that both the inverse piezoelectric effect and the positive piezoelectric effect improve as the wire diameter decreases.

The invention may be embodied in other forms without departing from the spirit or essential characteristics thereof. The embodiments disclosed in this application are to be considered in all respects as illustrative and not limiting. The scope of the invention is indicated by the appended claims rather than by the foregoing description, and all changes which come within the meaning and range of equivalency of the claims are intended to be embraced therein.

### Industrial Applicability

The present invention can provide ultrafine piezoelectric wires coated with a polymer piezoelectric material that exhibits a strong dielectric property without after-treatment such as drawing, and the piezoelectric wires can be applied to piezoelectric devices including various sensors and actuators.

### Description of Reference Numerals

- 10, 20, 30: piezoelectric wire
- 11: conductive wire
- 11a: wire end
- 12: polymer piezoelectric layer
- 13: conductive layer
- 14: insulating layer
- 41: function generator
- 42: amplifier
- 43: laser microscope
- 51: oscilloscope
- 52: charge amplifier
- 52a, 52b: electrode
- 53: tensile tester

## Claims

1. A piezoelectric wire comprising a conductive wire and a polymer piezoelectric layer that coats the conductive wire,
wherein the polymer piezoelectric layer contains a β-phase polyvinylidene fluoride-based copolymer, and
the conductive wire has a wire diameter of 1.0 mm or less.

2. The piezoelectric wire according to claim 1, wherein the β-phase polyvinylidene fluoride-based copolymer is at least one selected from a vinylidene fluoride-trifluoroethylene copolymer and a vinylidene fluoride-tetrafluoroethylene copolymer.

3. The piezoelectric wire according to claim 1 or 2, wherein the polymer piezoelectric layer has a thickness of 2 µm or more and 200 µm or less.

4. The piezoelectric wire according to any one of claims 1 to 3, wherein the conductive wire has a wire diameter of 0.5 mm or less.

5. The piezoelectric wire according to any one of claims 1 to 4, wherein the conductive wire has a wire diameter of 0.008 mm or more.

6. The piezoelectric wire according to any one of claims 1 to 5, wherein the conductive wire is a metal wire.

7. The piezoelectric wire according to any one of claims 1 to 6, further comprising a conductive layer on an outer surface of the polymer piezoelectric layer.

8. The piezoelectric wire according to claim 7, further comprising an insulating layer on an outer surface of the conductive layer.

9. A piezoelectric device comprising the piezoelectric wire according to any one of claims 1 to 8.

10. A method for producing the piezoelectric wire according to any one of claims 1 to 8, comprising:
a resin solution preparation step of preparing a resin solution by dissolving a β-phase polyvinylidene fluoride-based copolymer in a solvent;
an application step of applying the resin solution to a conductive wire;
a piezoelectric layer formation step of forming a polymer piezoelectric layer on a surface of the conductive wire by heating the conductive wire to which the resin solution has been applied; and
a polarization step of polarizing the polymer piezoelectric layer without drawing of the polymer piezoelectric layer.

11. A method for producing the piezoelectric wire according to any one of claims 1 to 8, comprising:
a resin melting step of melting a β-phase polyvinylidene fluoride-based copolymer by heating to prepare a molten resin;
an extrusion coating step of coating a conductive wire with the molten resin to form a polymer piezoelectric layer on a surface of the conductive wire; and
a polarization step of polarizing the polymer piezoelectric layer without drawing of the polymer piezoelectric layer.

12. The production method according to claim 10 or 11, further comprising a step of forming a conductive layer on a surface of the polymer piezoelectric layer.

13. The production method according to claim 12, further comprising a step of forming an insulating layer on a surface of the conductive layer.
